(19) Europäisches Patentamt

European Patent Office

Office européen des brevets

(11) **EP 1 220 350 B1**

(12) **EUROPEAN PATENT SPECIFICATION**

(45) Date of publication and mention
of the grant of the patent:
**06.12.2006 Bulletin 2006/49**

(21) Application number: **00956848.6**

(22) Date of filing: **31.08.2000**

(51) Int Cl.:
**H01M 10/42** (2006.01)

(86) International application number:
**PCT/JP2000/005925**

(87) International publication number:
**WO 2001/018899 (15.03.2001 Gazette 2001/11)**

(54) **ELECTRIC DEVICE WITH TIMER MEANS**

ELEKTRISCHE VORRICHTUNG MIT ZEITGEBER

APPAREIL ELECTRIQUE EQUIPE D'UN DISPOSITIF DE MINUTERIE

(84) Designated Contracting States:
**DE ES FR IT PT**

(30) Priority: **07.09.1999 JP 25338999**

(43) Date of publication of application:
**03.07.2002 Bulletin 2002/27**

(73) Proprietor: **TOKYO R & D Co., Ltd.**
**Minato-ku,**
**Tokyo 106-0032 (JP)**

(72) Inventors:
• **ISHII, Hiroshi**
**Tachikawa-shi,**
**Tokyo 190-0001 (JP)**
• **AOKI, Takashi**
**Musashimurayama-shi, Tokyo 208-0034 (JP)**

• **OHNUMA, Nobuhito,**
**Tokyo R&D Co., Ltd.,**
**Atsugi-shi,**
**Kanagawa 243-0035 (JP)**

(74) Representative: **Hofer, Dorothea et al**
**Prüfer & Partner GbR**
**Patentanwälte**
**Sohnckestrasse 12**
**81479 München (DE)**

(56) References cited:
**DE-A- 19 834 740        JP-A- 5 153 733**
**JP-A- 7 194 017         JP-A- 8 138 748**
**JP-A- 11 136 870**

• **PATENT ABSTRACTS OF JAPAN vol. 1999, no. 05, 31 May 1999 (1999-05-31) & JP 11 038106 A (OKI ELECTRIC IND CO LTD), 12 February 1999 (1999-02-12)**

**Description**

TECHNICAL FIELD

The present invention relates to an electric device of a compact electric automobile, an electric bicycle, an electric scooter, an electric wheelchair or the like, which is equipped with a secondary battery and runs on its electric power.

BACKGROUND TECHNOLOGY

There is an electric device of an electric vehicle such as a compact electric automobile, an electric bicycle, an electric scooter or an electric wheelchair, on which a battery pack composed of a plurality of storage batteries being secondary batteries is mounted as a power supply. The vehicles of this type include one running only on a driving force of an electric motor (motor) driven by electric power from the battery pack, one running on the resultant force of human power and a driving force of a motor, one selectively using a driving force of an ordinary gasoline engine and a driving force of a motor by electric power of a battery pack, and the like.

These battery packs being the electric power supply used for these electric devices need to be frequently charged. As a method of charging them, a method of charging the battery packs after detaching them from the electric devices on which they are mounted, a vehicle-mounted charging method of charging them while they are mounted on the electric devices as they are, and the like are usually used .

Incidentally, in such conventional electric devices, a remaining capacity of a secondary battery before being charged is insufficiently grasped, and a method of charging it by setting a charging time in a time period during which an electric vehicle is idle, based on intuition, experience and the like, is adopted.

Further, since the grasp of the remaining capacity of the secondary battery is insufficient, it happens that there is no remaining capacity when it is actually used, and it also happens that the vehicle cannot reach a destination since the remaining capacity is insufficient after operation. The completion time of charging cannot be accurately predicted, charge cannot be conducted at a specified time, or the maximum charge cannot be conducted by a specified time.

As means for making up for these disadvantages, for example, means for determining a remaining capacity by measuring output voltage of a secondary battery after a predetermined time elapses after the completion of charge so that the output voltage of the secondary battery, which apparently rises after the charge, is stabilized (JP, 8-106927, A), means for determining a remaining capacity by measuring the output voltage of the secondary battery after a predetermined time elapses after actuation to avoid the time when there are frequent changes in voltage at the time of actuation of an electric device (JP, 11-32401, A), and the like are proposed.

However, these prior arts are no better than the charge time management based on intuition, experience and the like as described above, and since time management (not elapsed time, but exact time, and the like) is not performed, time management in closer touch with a user's life cannot be carried out.

From JP 11-038106 A an electric device can be taken, comprising a rechargeable battery, a battery-low detecting section for detecting a voltage drop of the battery, a memory for storing the used time of the battery, a displaying means for the message of the state of the battery, a calendar timer having timer function, a battery charger and a charging controller, and a CPU which works as the controller and as a judging means.

The present invention is made to eliminate the disadvantages of the prior arts as described above, and its object is to improve accuracy with which the remaining capacity of a secondary battery is grasped, to make it possible to perform charge of the secondary battery at a suitable time. Another object is to make it possible to start charge by specifying time, to charge by specifying a charge completion time, or to calculate and indicate the charge completion time, and also to perform automatic refresh, automatic charge and the like of secondary batteries to thereby improve managing accuracy and handling ease of the secondary batteries especially in electric vehicles.

DISCLOSURE OF THE INVENTION

To achieve the above-described objects, the present invention provides an electric device with a timer, comprising a rechargeable secondary battery, a measuring means for measuring a state of the secondary battery and a memory for storing measured information thereof and information regarding properties of the secondary battery, a load of an electric motor driven by electric power supplied by the secondary battery, a controller for controlling drive of the load, a timer having a timer function, a display and operation unit having a time setting function for the timer and a time displaying function, and a battery manager for managing the secondary battery based on information of the measuring means and/or the memory and time information from the timer, and an interface capable of connecting a charger for charging the secondary battery based on information of the measuring means and/or the memory and time information from the timer.

The controller can also have a function of the battery manager.

Further, instead of the battery manager, and preferably in addition to the battery manager, it is preferable to include a charger for charging the secondary battery based on information of the measuring means and/or the memory and time information from the timer, and an interface for connecting a charger with the measuring means and/or the memory, and the timer and the controller.

The secondary battery, the measuring means and the memory may be constituted to be an integrated battery unit, and the battery unit may be mounted on an electric device main body to be attachable/detachable thereto/therefrom. Further, the charger may be constituted as a charger unit containing a charger section supplied with electric power from a commercial power supply or an alternative power supply and charging the secondary battery, and the charger unit may be mounted on an electric device main body to be attachable/detachable thereto/therefrom.

In the electric device provided with the charger, the display and operation unit can be provided with means for specifying a charge starting time, and the charger can be provided with means for starting charge for the secondary battery at the specified time.

Alternatively, the display and operation unit can be provided with means for specifying a charge completion time, and the charger can be provided with means for starting the charge so that the charge for the secondary battery is completed at the specified time.

The above electric devices may be provided with means actuated at a time specified by the timer, operating the measuring means and memory, and managing a residual capacity of the secondary battery based on a self discharge amount and a consumption capacity according to properties of the secondary battery.

In the electric device provided with the charger, it is preferable to provide means actuated at a time specified by the timer, operating the measuring means and memory, managing a residual capacity of the secondary battery based on a self discharge amount and a consumption capacity according to properties of the secondary battery, and making the charger charge the secondary battery when it needs to be charged.

BRIEF DESCRIPTION OF DRAWINGS

FIG. 1 is a block circuit diagram of an electric device showing one embodiment of the present invention;
FIG. 2 is a block circuit diagram showing a concrete example of a measuring means inside a battery unit in FIG. 1;
FIG. 3 is a flowchart showing a setting action of time-specified charge in an electric device shown in FIG. 1;
FIG. 4 is a flowchart showing an action of the time-specified charge of the same;
FIG. 5 is a flowchart showing an action of performing the time-specified charge after refresh of the secondary battery of the same;
FIG. 6 is a flowchart showing a setting action of charge completion time specified charge of the same;
FIG. 7 is a flowchart showing an action of the charge completion time specified charge of the same;
FIG. 8 is a flowchart showing a remaining capacity correction action for the secondary battery during non-operation time of the electric device shown in FIG. 1; and
FIG. 9 is a flowchart showing an action of performing automatic charge when charge is needed after the remaining capacity correction for the secondary battery of the same.

BEST MODE FOR CARRYING OUT THE INVENTION

Hereinafter, a preferred embodiment of the present invention will be described based on the drawings.

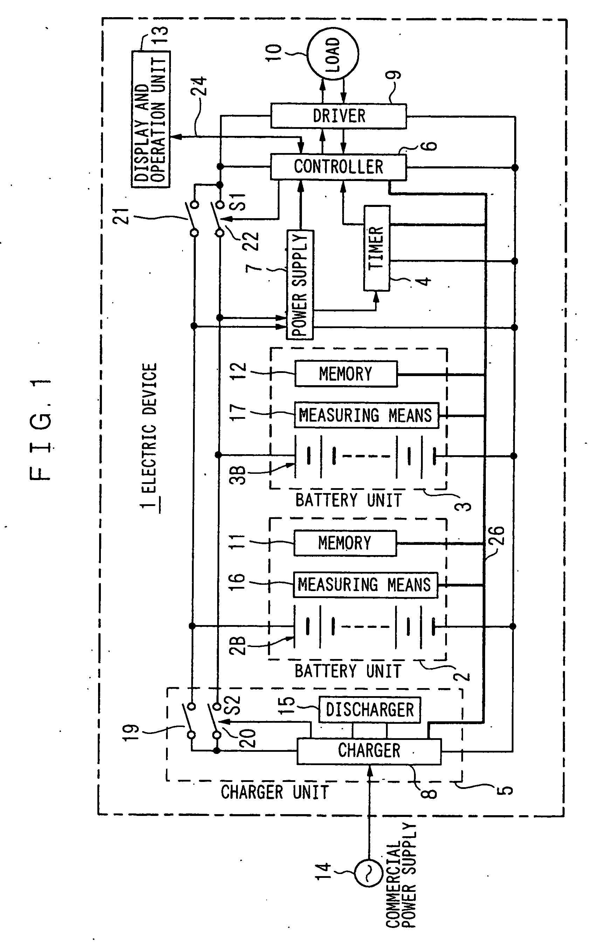

FIG. 1 is a block circuit diagram showing an embodiment of an electric device according to the invention.

An electric device 1 of this embodiment is constituted by battery units 2 and 3 (an example constituted by two battery units is shown in this embodiment, but one or more may be suitable), a timer 4, a charger unit 5, a controller 6, a power supply 7, a display and operation unit 13, a driver 9, and a load 10.

The charger unit 5 is constituted by a charger 8 including a control function by means of a microcomputer or the like, supplied with electric power from a commercial power supply 14 or an alternative power supply and charging the battery units 2 and 3; switches 19 and 20 controlled by a switch control signal S2 from the charger 8 to switch to either the battery unit 2 or battery unit 3 to be charged; a discharger 15 for making the battery units 2 and 3 discharge under the control by the control function of the charger 8 to refresh a nickel-cadmium (Ni-Cd) secondary battery or a nickel-metal hydride (Ni-MH) secondary battery producing a memory effect; and an interface (not shown) with a system bus 26.

The battery units 2 and 3 are constituted by rechargeable secondary batteries (including battery packs composed of a plurality of storage batteries or alternative energy storage elements) 2B and 3B respectively; measuring means 16 and 17 constituted by a measurement circuit for performing voltage detection and charge and discharge current detection of necessary parts of the secondary batteries 2B and 3B (of cell unit, a plurality of cells, the entire part and the like that are needed by the electric device to obtain the properties of the batteries) and detection of temperature of the necessary part, ambient temperature and the like, and an interface for outputting the measured data to the system bus 26; and memories 11 and 12 constituted by a non-volatile memory such as an EEPROM for storing the properties of the batteries and battery information needed by the electric device, including at least remaining capacities of the secondary batteries 2B and 3B, and an interface for making it possible to read and write the data via the system bus 26.

The controller 6 includes a control function by means of a microcomputer or the like, and has a function of performing a main control of the operation of the electric device, such as determining which battery unit is used according to the operation information from the display and operation unit 13, the battery information stored in the memories 11 and 12 of the battery units 2 and 3 and the like, selecting which one of the battery units 2 and 3 is used by switching switches 21 and 22 according to a switch control signal S1, and how the driver 9 is operated. Further, the controller 6 has a function of battery manager according to the invention.

The controller 6 also has an interface with the display and operation unit 13 and the system bus 26, a function of shifting the electric device into an electric power-saving state at a non-operation time, and a function of returning from the electric power-saving state by a wake-up signal WU from the timer 4.

The power supply 7 supplies necessary electric power to the controller 6 and the timer 4 that will be described later by electric power supplied from the battery units 2 and 3 and the charger unit 5.

The timer 4 always operates by electric power supplied from the power supply 7, and has a function of outputting the wake-up signal WU at a determined time and/or after a lapse of a determined time.

Further, the constitution is made so that it is possible to indicate a time to a display section of the display and operation unit 13 via the controller 6 and to set a time by operating an operation section thereof.

The display and operation unit 13 is constituted by the display section composed of an LCD display or the like for displaying necessary states and information such as a state of the electric device 1, a state of the charger 8 of the charger unit 5 and time; and the operation section composed of a plurality of keys, buttons, a touch panel or the like capable of instructing the operation of the electric device 1, time setting for the timer 4 (including designation of charge starting time and charge completion time that will be described later), and other necessary instruction operations. Display is performed according to a signal from the controller 6 and operation information is sent to the controller 6 via an operation bus 24. Further, a buzzer or the like which sounds in response to the instruction from the controller 6 is included as necessary.

The system bus 26 is a bus used for transferring information to and from the charger 8 of the charger unit 5, the measuring means 16 and 17 and the memories 11 and 12 of the battery units 2 and 3, the timer 4 and the controller 6, and is generally constituted by a data bus, an address bus and a control bus, but a serial bus, a parallel bus or any other constitution may be adopted if only information can be transferred to and from each unit and component.

The driver 9 receives electric power from the battery units 2 and 3, and controls and drives the load 10 according to a signal from the controller 6.

The load 10 includes an electric motor (motor), an actuator, lamps and the like, for attaining an object of the electric device 1. The electric motor drives a traveling unit such as wheels and the like to make the electric device 1 run. The actuator actuates a brake and the like. The lamps are lamps such as headlights, tail lights, winker lamps and the like.

The battery units 2 and 3 and the charger unit 5 may be fixedly provided at an electric device main body (vehicle body), but it is convenient if they are provided as detachable units.

In this case, it is suitable to provide a connector for connecting/disconnecting a power line and a bus inside the battery units 2 and 3 and the charger unit 5 to/from a power line at the side of the electric device main body and the system bus 26 in response to attachment and detachment of the battery units 2 and 3 and the charger unit 5, a lock mechanism for locking the mounted units so that they are not easily detached, and the like.

In this way, when the secondary battery of any one of the battery units 2 and 3 has less remaining capacity and needs to be charged, it is convenient because the battery unit (2 or 3) and the charger unit 5 can be removed from the electric device and charge can be performed at a place with the commercial power supply 14 while electric power is supplied to the load 10 and the like from the other battery unit to make it possible to operate the electric device 1.

Further, since the charger unit 5 being a charger is mounted on the electric device 1 in this embodiment, charge can be conducted with the battery units 2 and 3 being mounted on the electric device as they are, but it may be suitable to place a charger device at a place with the commercial power supply 14 or an alternative power supply outside the electric device instead of providing the charger in the electric device, then remove the battery units 2 and 3 from the electric device 1 and connect them to the charger device to conduct charge. Accordingly, as the electric device, it is not essential to be equipped with the charger.

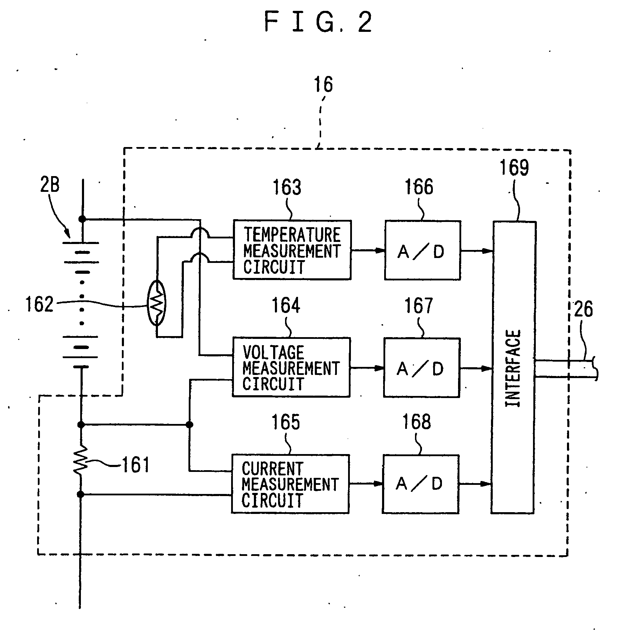

Here, a concrete example of the measuring means 16 provided at the battery unit 2 is shown in FIG. 2. It should be noted that the measuring means 17 provided at the battery unit 3 has the same constitution as this.

The measuring means 16 is constituted by a resistance 161 with a small resistance value for measuring an electric current, which is connected in series with the secondary battery 2B, a thermistor 162 being a sensor for measuring temperature, which is provided in close contact with or in the vicinity of the secondary battery 2B, a temperature measurement circuit 163, a voltage measurement circuit 164, a current measurement circuit 165, A/D conversion circuits 166, 167 and 168, and an interface 169 with the system bus 26.

The temperature measurement circuit 163 measures the temperature of the secondary battery 2B or the ambient temperature by converting a change in a resistance value caused by temperature of the thermistor 162 into a voltage, converts the measured value into a digital value with the A/D conversion circuit 166, and outputs it to the system bus 26 via the interface 169. If the thermistor 162, the temperature measurement circuit 163, and the A/D conversion circuit 166 are provided for each cell of the secondary battery 2B, or for each of a plurality of cell groups, the temperature measurement can be carried out more minutely.

The voltage measurement circuit 164 measures terminal voltage of the secondary battery 2B, converts the measured value into a digital value with the A/D conversion circuit 167, and outputs it to the system bus 26 via the interface 169. If the voltage measurement circuit 164 and the A/D conversion circuit 167 are provided for each cell of the secondary battery 2B, or for each of a plurality of cell groups, the voltage measurement can be carried out more minutely.

The current measurement circuit 165 measures a value of a discharge current or a charge current of the secondary battery 2B by measuring voltage drop caused by the resistance 161, converts the measured value into a digital value with the A/D conversion circuit 168, and outputs it to the system bus 26 via the interface 169. Instead of the resistance 161, the current passing into the secondary battery 2B can be also measured by using a hall device, a current transformer, or the like.

Next, charge action for the battery units 2 and 3 by the charger unit 5 in this embodiment will be explained.

In this embodiment, charge is started when the charger unit 5 is connected to the commercial power supply 14 or an alternative power supply and electric power is supplied to the charger 8. The charger 8 converts a supplied alternating-current input into direct-current voltage suitable for charging and outputs it.

Further, the charger 8 includes a control function by a microcomputer or the like and can execute time-specified charge, immediate charge, charge completion time set charge and the like as a charge mode, and these charge modes can be set by a predetermined operation by the display and operation unit 13 during operation time of the electric device 1 or at the time of charge. The charger 8 holds the set content of the charge mode and starts charge in the held charge mode with reference thereto for each charge.

Since the remaining capacity management is performed based on the battery properties such as the frequency of use, ambient temperature, charging efficiency and the like of each of the secondary batteries 2B and 3B of the battery units 2 and 3, and a discharge current integrated value, detected voltage or the like, the influence is given by its accuracy, system properties and the like, but what is not directly related to this invention is disregarded. The battery capacity is a basic capacity that the battery has.

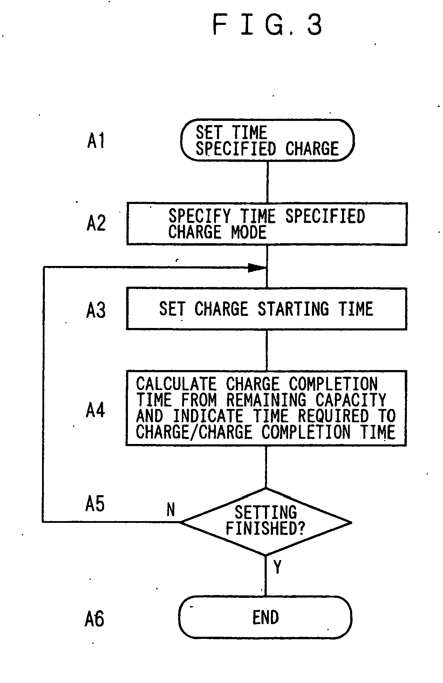

First, a method of setting the charge-time-specified charge for charging with the charge starting time being specified will be explained according to a flowchart in FIG. 3.

Setting of the time-specified charge is carried out by the charger 8 of the charger unit 5 via the controller 6 according to an instruction from the display and operation unit 13 following the procedure from steps A1 to A6 shown in FIG. 3.

A1: Enter the setting of a charge mode by a predetermined operation on the display and operation unit 13.

A2: When the time-specified charge mode is specified (specify with keys or the like of the operation section), input of the charge starting time is required.

A3: When the charge starting time is inputted by a key operation on the display and operation unit 13, it is set (stored in the memory of the charger 8).

A4: The charger 8 is given remaining capacity information from each of the memories 11 and 12 of the battery units 2 and 3, and the present time information from the timer 4, via the system bus, and calculates a charging time (time required to charge) from the remaining capacity.

The charging time is calculated based on the following equation in the case of a constant-current charge battery.

$$\text{Charging time} = (\text{battery capacity} - \text{remaining capacity}) \div \text{charge current}$$

In the case of constant-current and constant-voltage charge, a remaining capacity (charged capacity) at the time of completion of the constant-current charge is checked in advance and a time to remaining capacity (charged capacity) relation during the constant-voltage charge is checked and tabulated to make the following calculation.

With the constant-current period: (battery capacity - remaining capacity) ÷ charge current = T1

With the constant-voltage charge time = T2, charging time = T1 + T2

Without the constant-current period: based on charging time = (battery capacity - remaining capacity), calculation is made according to the table.

Based on the charging time calculated from the above and the present time, the display and operation unit 13 is made to indicate a predetermined display, for example, a time required to charge and/or the inputted charge starting time, or a time after the time required to charge from the charge starting time, which is a charge completion time.

A5, A6: Thereafter, when the completion of the setting operation is confirmed (pressing down a confirmation key is detected), setting of the time-specified charge is finished.

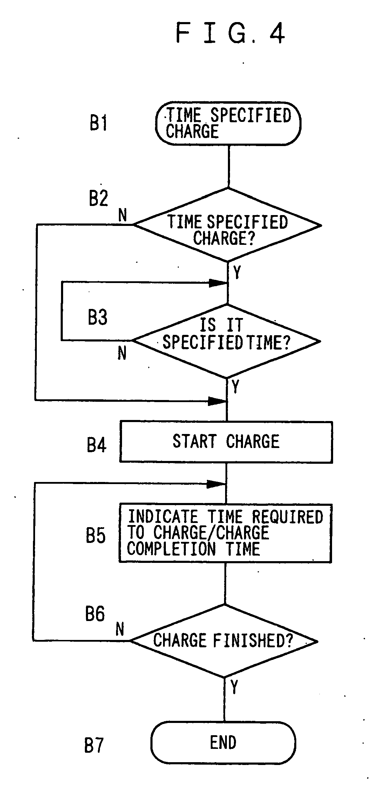

Next, according to a flowchart in FIG. 4, charge action when the time-specified charge is set will be explained.

The time-specified charge is carried out by the charger 8 of the charger unit 5 following the procedure from steps B1 to B7 in FIG. 4.

B1: When electric power is supplied to the charger 8 from the commercial power supply 14 or an alternative power supply, the charger 8 goes into a charge mode.

B2: Whether it is the time-specified charge or not is checked, and if it is one of the other charge modes, it immediately proceeds to B4 and starts charge. If it is the time-specified charge, it proceeds to B3.

B3: It obtains present time information from the timer 4, compares it with the specified charge starting time that is stored, and waits until the specified time. When the present time corresponds to the charge starting time, it proceeds to B4.

B4: It starts the charge. Specifically, the charger 8 turns ON either switch 19 or 20 according to the switch control signal S2, selects the battery unit 2 or 3 to be charged, and supplies charge electric power to the secondary battery 2B or 3B of the selected battery unit to start the charge.

B5: At the time of starting the charge, it displays the time required to charge obtained at the setting of the charge time specified charge and/or charge completion time, and as the charge proceeds, it calculates the charging time as a value which is found by adding charged capacity to the remaining capacity to indicate the time taken before the completion of the charge and /or charge completion time in succession.

B6, B7: Thereafter, it checks the completion of the charge, if the charge is not finished, it continues the charge in B5, and if it confirms the completion of the charge, it finishes the charge processing.

In this example, one of the battery units 2 and 3 is selected and its secondary battery is charged, but if two of the battery units 2 and 3 need to be charged, one of the secondary batteries is charged and thereafter the other of the secondary batteries is selected and charged. At this time, it is natural that the time required to charge is what is found by adding up the times required to charge of the respective secondary batteries.

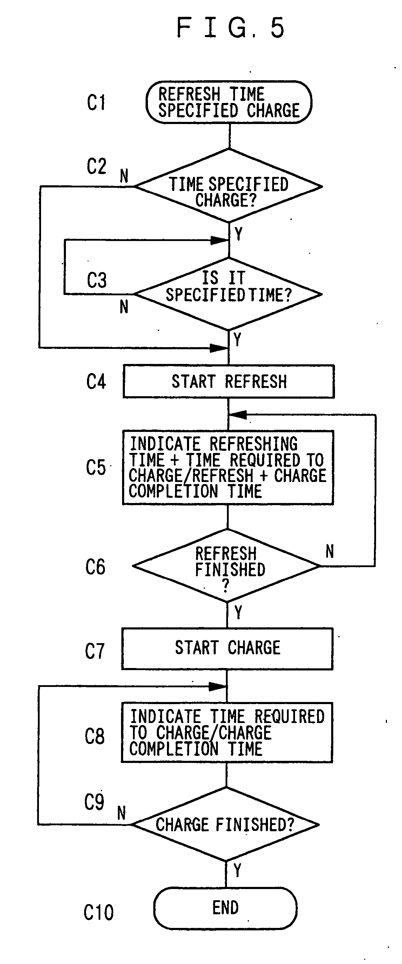

Next, based on FIG. 5, action of time-specified charge after refresh action will be explained regarding a battery requiring to be refreshed because of a memory effect such as a nickel-cadmium secondary battery, a nickel-metal hydride secondary battery or the like.

The memory effect means that the capacity of the battery decreases after it is used by repeating charge and discharge in a state of a shallow charge depth.

The action in this case is conducted by the charger 8 following the procedure from steps C1 to C 10 in FIG. 5.

C1: When electric power is supplied to the charger 8 from the commercial power supply or an alternative power supply, the charger 8 goes into a refresh and time-specified charge mode.

C2, C3: First, it checks whether it is the time-specified charge or not, and if it is one of the other charge modes, it proceeds to C4 immediately and starts refresh. If it is the time-specified charge, it obtains the present time information from the timer 4 in C3 and compares it with the specified charge starting time that is stored. When the present time corresponds to the charge starting time, it proceeds to C4 and starts refresh.

C4: It starts refresh. Specifically, the charger 8 turns ON either the switch 19 or 20 according to the switch control signal S2, selects either the battery unit 2 or 3, connects the secondary battery 2B or 3B to the discharger 15 and makes it discharge, whereby refresh is conducted.

C5: After the refresh is started, based on the time obtained by adding up a refreshing time calculated as will be described later and a time required to charge that is obtained as explained in the charge action when the time-specified charge is set, a total time required to refresh and charge and/or completion time of the charge after the refresh are/is indicated at the display and operation unit 13.

The calculation of refreshing time is performed according to the following equation.

$$\text{Refreshing time} = \text{remaining capacity} \div \text{discharge current}$$

It should be noted that constant-current discharge, constant-electric-power discharge, constant-resistance discharge and the like can be considered as discharge of the discharger 15, and in this explanation, constant-current discharge is adopted.

As discharge proceeds, refreshing time is calculated as a value obtained by subtracting a discharged capacity from a remaining capacity, and a period (of time) display and/or a time display are renewed in succession.

C6: During execution of the refresh, the charger 8 obtains information from the measuring means 16 and 17 via the system bus 26, and checks the completion of the refresh action according to predetermined conditions by the battery properties. Discharge is continued in C5 until the refresh is finished, and when the refresh is finished, it proceeds to C7.

C7: It supplies charge electric power to the refreshed secondary battery 2B or 3B to start charge.

C8: At the time of starting the charge, it first indicates an obtained required time to charge and/or a charge completion time, and as the charge proceeds, it calculates the required time to charge from a value that is found by adding a charge capacity to the remaining capacity to renew the indication of the charging time and/or the charge completion time in succession.

C9, C10: Subsequently, it checks the completion of the charge, if the charge is not completed, it continues the charge, and if it confirms the completion of the charge, it finishes the charge processing.

In this example, one of the battery units 2 and 3 is selected, and its secondary battery 2B or 3B is charged after being refreshed, but when both of the secondary batteries 2B and 3B of the two battery units 2 and 3 need to be charged after refresh, one of the secondary batteries is charged after the refresh, and thereafter the other battery unit is selected and its secondary battery is charged after the refresh. At this time, it is natural that the refreshing time and the required time to charge is the result of adding up the refreshing times and the required times to charge of the two secondary batteries.

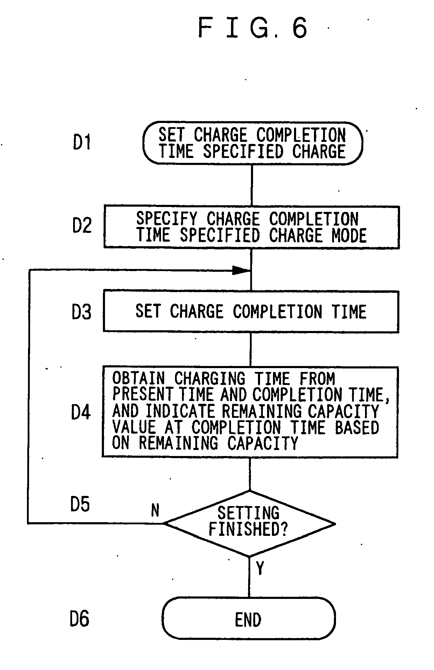

Next, action of setting charge completion time specified charge will be explained based on a flowchart in FIG. 6. This setting action is carried out following the procedure from steps D1 to D6 in FIG. 6.

D1: Go into setting of the charge mode by a predetermined operation on the display and operation unit 13.

D2: Subsequently, when the charge completion time specified charge mode is designated, input of charge completion time is required.

D3: When the required charge completion time is inputted, the charger 8 stores it in the memory.

D4: It obtains remaining capacity information from the memory 11 or 12 of the battery unit 2 or 3 via the system bus 26, and present time information from the timer 4. Subsequently, it calculates chargeable time from the present time, and obtains a remaining capacity at the completion time.

The calculation of the remaining capacity is made as follows.

In the case of a constant-current charge battery,

$$\text{Remaining capacity} = \text{remaining capacity} + \text{charge current} \times \text{chargeable time}$$

(The maximum remaining capacity is the battery capacity, and if it is exceeded, the charge is finished.)

In the case of a constant-current and constant-voltage charge,

The remaining capacity (charged capacity) at the time of completion of the constant-current charge is previously checked, and a time to remaining capacity (charged capacity) relation at the time of the constant-voltage charge is checked and tabulated.

When the constant-current period exists;

$$\text{Remaining capacity (T1)} = \text{remaining capacity at start of charge} + \text{charge current} \times T1$$

$$\text{Charged capacity} = \text{charged capacity in (chargeable time} - T1) \text{ is calculated from the table.}$$

$$\text{Remaining capacity} = \text{remaining capacity (T1)} + \text{charged capacity}$$

(The maximum remaining capacity is the battery capacity, and if it is exceeded, the charge is finished.)

When a constant-current period does not exist;

$$\text{Remaining capacity} = \text{remaining capacity at start of charge} + (\text{charged}$$
$$\text{capacity in the chargeable time calculated from the table})$$

(The maximum remaining capacity is the battery capacity, and if it is exceeded, the charge is finished.)

The remaining capacity calculated as above is indicated on the display and operation unit 13.

D5, D6: Thereafter, when the completion of the setting operation is confirmed, this action is finished.

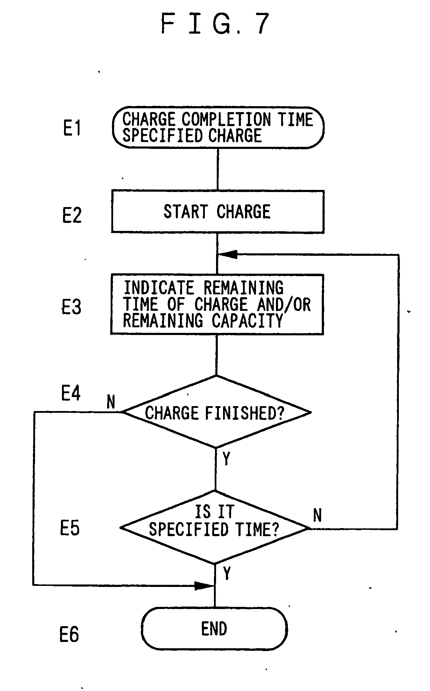

Next, charge action when the charge completion time specified charge is set will be explained based on a flowchart in FIG. 7. The charge action is carried out following the procedure from steps E1 to E6 in FIG. 7.

E1: When the charger 8 is supplied with electric power from the commercial power supply 14 or an alternative power supply, it goes into charge action.

E2: It starts charge. Specifically, the charger 8 turns ON either the switch 19 or 20 according to the switch control signal, selects either the battery unit 2 or 3, and its secondary battery 2B or 3B is connected to start the charge.

E3: During the charge, it indicates remaining time of the charge obtained from the specified completion time and the present time, and/or the remaining capacity (obtained by the same method as explained about the charge completion time setting based on the elapsed time) changed according to the elapsed charge time.

E4, E5, E6: The charger 8 checks the completion of the charge in E4, and when the charge is completed, it proceeds to E6 to finish the charge. When the charge is not completed, it compares the specified charge completion time and the present time in E5, and when it is the charge completion time (specified time), it proceeds to E6 to finish the charge. If it is not the charge completion time (specified time), it returns to E3 to continue the charge.

In this example, one of the battery units 2 and 3 is selected and its secondary battery 2B or 3B is charged, but when both of the secondary batteries 2B and 3B of the two battery units 2 and 3 need to be charged, one of the secondary batteries is charged and thereafter the other battery unit is selected to charge the secondary battery. At this time, the remaining capacity is indicated for each battery unit.

Though it is not shown in the drawings, when refresh is needed, the time from which refreshing time is excluded may be the chargeable time.

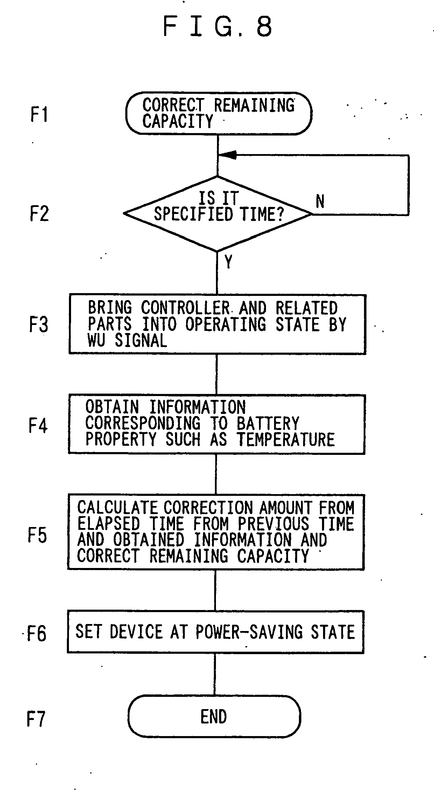

Next, based on a flowchart in FIG. 8, the remaining capacity correction of the secondary battery during non-operation time of the electric device 1 will be explained. This action is carried out by the timer 4 and the controller 6 in FIG. 1 following the procedure from steps F1 to F7 in FIG. 8.

In this embodiment, the electric device 1 is in a power-saving state except for charge action and operating state and action of the timer function, and reduction in the remaining capacity of the secondary batteries 2B and 3B is decreased as much as possible.

F1: When the electric device 1 continues to be in the non-operation state and in the state in which charge action is not carried out for a predetermined period of time, the controller 6 stops power supply to the electric device 1 except to the parts requiring a minimum amount (the timer 4, the controller 6 and the like) and brings it into a power-saving state to go into the action of the remaining capacity correction.

F2: The timer 4 determines whether it is a specified time (specified elapsed time is acceptable) or not, and when it is the specified time, it outputs the wake-up signal WU.

F3: The controller 6 starts action according to the wake-up signal WU, and brings the related parts, for example, the measuring means 16 and 17 into an operating state.

F4: Subsequently, the controller 6 obtains information necessary for the remaining capacity correction according to the properties of the secondary battery such as temperature and the like from the measuring means 16 and 17, the memories 11 and 12 and the like via the system bus 26.

F5: It calculates the correction capacity from the elapsed time from the previous correction and the obtained information, and the remaining capacity of the secondary batteries 2B and 3B is corrected. For example, if self-discharge of the secondary batteries 2B and 3B is determined by time and temperature, the average value of the previous temperature and obtained temperature is taken, and self-discharge amount is found from the relation with time based on the information previously stored in the memories 11 and 12 and the like, whereby correction information is obtained.

Further, a used capacity of the secondary battery in the power-saving state is found based on the used electric power and elapsed time in the power-saving state, and the value of the remaining capacity stored in the memories 11 and 12 is corrected with the above-described self-discharge amount and the used capacity in this action.

F6, F7: After the correction, the electric device is set at the power-saving state again to finish this action.

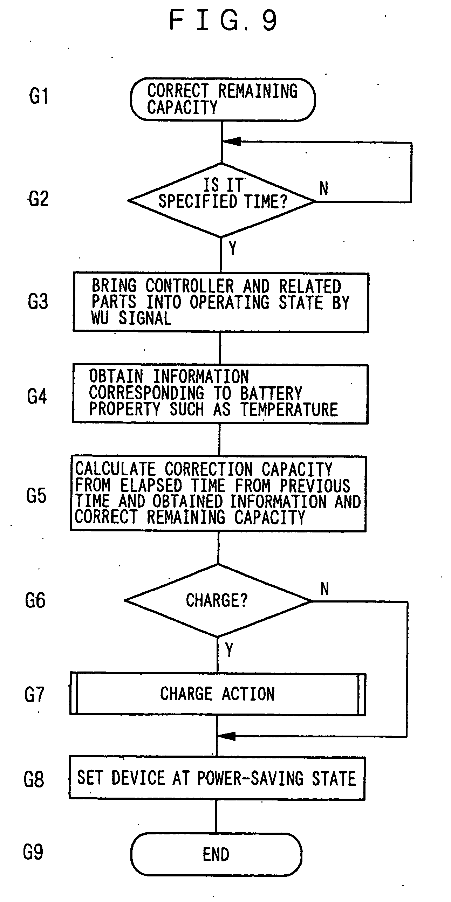

Next, based on a flowchart in FIG. 9, action to charge and maintain a remaining capacity set in advance, when the remaining capacity becomes a predetermined remaining capacity at the time of correction of the remaining capacity, will be explained. This action is carried out by the timer 4, the controller 6 and the charger 8 in FIG. 1 following the procedure from steps G1 to G9 in FIG. 9.

In order to execute this action, the charger 8 of the charger unit 5 needs to be supplied with electric power from the commercial power supply 14 or an alternative power supply.

Steps G1 to G5 are the same as steps F1 to F5 explained in FIG. 8.

G6 to G9: After the remaining capacity is corrected in G5, whether charge is necessary or not is determined by the determination of whether the remaining capacity is not more than a capacity set in advance in G6. If the capacity exceeds the set capacity, charge is determined as unnecessary to proceed to G8, and the electric device is set at the power-saving state again, and the action is finished in G9.

If the capacity is not more than the set capacity, charge is determined as necessary, then charge action is carried out until the remaining capacity becomes the predetermined remaining capacity in G7, then after the remaining capacity is stored in the memory 11 or 12 as the remaining capacity of the battery at the point of time of completion of the charge, the electric device 1 is set at the power-saving state in G8, and the action is finished in G9.

According to the electric device in this embodiment, the effects cited below are obtained.

(1) The time-specified charge makes it possible to charge the secondary battery of the battery unit using, for example, midnight electric power, and reduce charging cost and use electric facilities uniformly.

(2) Storage of a remaining capacity of the secondary battery and setting of a charge starting time make it possible to calculate and indicate a charge completion time. When the secondary battery is refreshed, refreshing time is calculated from a remaining capacity and the refreshing time is regarded.

(3) Storage of a remaining capacity of the secondary battery and setting of a charge completion time make it possible to make determination whether the charge is completed by the set time or not, give indication and an alarm (when the charge is not completed), and the like, as well as to calculate and indicate the charge amount when the charge is carried out. Further, when a plurality of secondary batteries are mounted, it is possible to select the battery which can be charged most within the determined time and charge it.

When charge is carried out by a constant-current and constant-voltage method, the battery with less remaining capacity in a constant-current charge area has more charge amount. When the secondary battery is refreshed, refreshing time calculated from a remaining capacity is regarded.

(4) Only the timer function section is operated at the non-operation time, then at a predetermined time by the timer function, a necessary part is operated to detect an environment of the battery, and correction of the remaining capacity of the secondary battery is made based on consumed current during the non-operation time, the detection data, the properties of the secondary battery, time information by the timer and the like, whereby accuracy with which the residual capacity is grasped can be improved.

Further, when charge is necessary, indication and an alarm can be given, and therefore the electric device is kept in a state in which it can be effectively used. At this time, when the commercial power supply or an alternative power supply is connected to the charger, it is possible to automatically charge the secondary battery instead of giving indication and an alarm, and thus usability of the electric device is further improved.

INDUSTRIAL APPLICABILITY

As has been described, the electric device of an electric vehicle or the like according to the invention makes it possible to improve accuracy with which a remaining capacity of the secondary battery is grasped and to charge the secondary battery at appropriate times. Further, start of charge by specifying time, charge by specifying the charge completion time or calculation and indication of the charge completion time, automatic refresh and automatic charge of the secondary battery, and the like can be made, and controlling accuracy and handling ease of the secondary battery especially in an electric vehicle can be improved.

**Claims**

1. An electric device (1) of an electric vehicle with a timer (4), comprising:

a rechargeable secondary battery (2B, 3B);
a measuring means (16, 17) for measuring a state of said secondary battery (2B, 3B) and a memory (11, 12) for storing measured information thereof and information regarding properties of said secondary battery (2B, 3B);
a load (10) of an electric motor driven by electric power supplied by said secondary battery (2B, 3B);

a controller (6) for controlling drive of said load (10);

a timer (4) having a timer function;

a display and operation unit (13) having a time setting function for said timer (4) and a time displaying function;

a battery manager for managing said secondary battery (2B, 3B) based on information of said measuring means (16, 17) and/or said memory (11, 12) and time information from said timer (4); and

an interface (169) capable of connecting a charger (8) via a system bus (26) for charging said secondary battery (2B, 3B) based on information of said measuring means (16, 17) and/or said memory (11, 12) and time information from said timer (4).

2. The electric device according to claim 1, wherein

said controller (6) also has a function of said battery manager for managing said secondary battery (2B, 3B) based on information of said measuring means (16, 17) and/or said memory (11, 12) and time information from said timer (4).

3. An electric device (1) of an electric vehicle with a timer (4), comprising:

a rechargeable secondary battery (2B, 3B);

a measuring means (16, 17) for measuring a state of said secondary battery (2B, 3B) and a memory (11, 12) for storing measured information thereof and information regarding properties of said secondary battery (2B, 3B);

a load (10) of an electric motor driven by electric power supplied by said secondary battery (2B, 3B);

a controller (6) for controlling drive of said load (10);

a timer (4) having a timer function;

a display and operation unit (13) having a time setting function for said timer (4) and a time displaying function

a charger (8) for charging said secondary battery (2B, 3B) based on information of said measuring means (16, 17) and/or said memory (11, 12) and time information from said timer (4); and

an interface (169) for connecting said charger (8) with said measuring means (16, 17) and/or said memory (11, 12), and said timer (4) and said controller (6) via a system bus (26).

4. The electric device according to claim 3, wherein

said controller (6) also has a function of a battery manager for managing said secondary battery (2B, 3B) based on information of said measuring means (16, 17) and/or said memory (11, 12) and time information from said timer (4).

5. The electric device according to claim 1 or 3, wherein

said secondary battery (2B, 3B), said measuring means (16, 17) and said memory (11, 12) are constituted to be an integrated battery unit (2, 3), and the battery unit (2, 3) is mounted on an electric device main body to be attachable/detachable thereto/therefrom.

6. The electric device according to claim 4, wherein

said display and operation unit (13) is provided with a time specifying means for specifying a charge completion time, and said charger (8) is provided with means for starting charge so that the charge for said secondary battery (2B, 3B) is completed at a time specified by the time specifying means.

7. The electric device according to claim 1 or 3, further comprising:

means actuated at a time specified by said timer (4), operating said measuring means (16, 17) and said memory (11, 12), and managing a residual capacity of said secondary battery (2B, 3B) based on a self discharge amount and a consumption capacity according to properties of said secondary battery (2B, 3B).

8. The electric device according to claim 3 or 4, further comprising:

means actuated at a time specified by said timer (4), operating said measuring means (16, 17) and memory (11, 12), managing a residual capacity of said secondary battery (2B, 3B) based on a self discharge amount and a consumption capacity according to properties of said secondary battery (2B, 3B), and making said charger (8) charge said secondary battery (2B, 3B) when it needs to be charged.

**Patentansprüche**

1. Elektrische Vorrichtung (1) eines elektrischen Fahrzeuges mit einem Zeitgeber (4), mit:

einer wieder aufladbaren Sekundärbatterie (2B, 3B);

einem Messmittel (16, 17) zum Messen eines Zustandes der Sekundärbatterie (2B, 3B) und einem Speicher (11, 12) zum Speichern der gemessenen Informationen davon und Information bezüglich von Eigenschaften der Sekundärbatterie (2B, 3B);

einer Last (10) eines Elektromotors, der von elektrischer Leistung angetrieben wird, die von der Sekundärbatterie (2B, 3B) geliefert wird;

einer Steuerung (6) zum Steuern des Treibens der Last (10) ;

einem Zeitgeber (4) mit einer Zeitgeberfunktion;

einer Anzeige- und Betätigungseinheit (13) mit einer Zeiteinstellfunktion für den Zeitgeber (4) und einer Zeitanzeigefunktion;

einem Batteriemanager zum managen der Sekundärbatterie (2B, 3B) auf der Grundlage von Informationen von dem Messmittel (16, 17) und/ oder dem Speicher (11, 12) und Zeitinformation von dem Zeitgeber (4); und

einer Schnittstelle (169), die einen Lader (8) über einen Systembus (26) zum Laden der Sekundärbatterie (2B, 3B) auf der Grundlage von Information von dem Messmittel (16, 17) und/ oder dem Speicher (11, 12) und Zeitinformation von dem Zeitgeber (4) verbinden kann.

2. Elektrische Vorrichtung nach Anspruch 1, bei der die Steuerung (6) auch eine Funktion des Batteriemanagers aufweist zum Managen der Sekundärbatterie (2B, 3B) auf der Grundlage von Informationen von dem Messmittel (16, 17) und/ oder dem Speicher (11, 12) und Zeitinformation von dem Zeitgeber (4) .

3. Elektrische Vorrichtung (1) eines elektrischen Fahrzeuges mit einem Zeitgeber (4) mit:

einer wieder aufladbaren Sekundärbatterie (2B, 3B);

einem Messmittel (16, 17) zum Messen eines Zustandes der Sekundärbatterie (2B, 3B) und einem Speicher (11, 12) zum Speichern gemessener Information davon und Information bezüglich Eigenschaften der Sekundärbatterie (2B, 3B);

einer Last (10) eines Elektromotors, der von elektrischer Leistung angetrieben wird, die von der Sekundärbatterie (2B, 3B) geliefert wird;

einer Steuerung (6) zum Steuern des Treibens der Last (10) ;

einem Zeitgeber (4) mit einer Zeitgeberfunktion;

einer Anzeige- und Betätigungseinheit (13) mit einer Zeiteinstellfunktion für den Zeitgeber (4) und einer Zeitanzeigefunktion;

einem Lader (8) zum Laden der Sekundärbatterie (2B, 3B) auf der Grundlage von Information von dem Messmittel (16, 17) und/ oder dem Speicher (11, 12) und Zeitinformation von dem Zeitgeber (4); und

einer Schnittstelle (169) zum Verbinden des Laders (8) mit dem Messmittel (16, 17) und/ oder dem Speicher (11, 12) und dem Zeitgeber (4) und der Steuerung (6) über einen Systembus (26).

4. Elektrische Vorrichtung nach Anspruch 3, bei der
die Steuerung (6) auch eine Funktion eines Batteriemanagers zum Managen der Sekundärbatterie (2B, 3B) auf der Grundlage von Information von dem Messmittel (16, 17) und/ oder dem Speicher (11, 12) und Zeitinformation von dem Zeitgeber (4) aufweist.

5. Elektrische Vorrichtung nach Anspruch 1 oder 3, bei der
die Sekundärbatterie (2B, 3B), das Messmittel (16, 17) und der Speicher (11, 12) aus einer integrierten Batterieeinheit (2, 3) aufgebaut sind und die Batterieeinheit (2, 3) auf einem Hauptkörper einer elektrischen Vorrichtung so angebracht ist, dass sie daran anbringbar/ davon abnehmbar ist.

6. Elektrische Vorrichtung nach Anspruch 4, bei der
die Anzeige- und Betätigungseinheit (13) mit einem Zeitspezifizierungsmittel zum Spezifizieren einer Ladebeendigungszeit versehen ist und der Lader (8) mit einem Mittel zum Starten des Ladens so versehen ist, dass das Laden für die Sekundärbatterie (2B, 3B) zu einer Zeit beendet ist, die durch das Zeitspezifizierungsmittel spezifiziert ist.

7. Elektrische Vorrichtung nach Anspruch 1 oder 3, weiter mit:

einem Mittel, das zu einer Zeit betätigt wird, die durch den Zeitgeber (4) spezifiziert ist,
Betreiben des Messmittels (16, 17) und des Speichers (11, 12), und Managen einer Restkapazität der Sekundärbatterie (2B, 3B) auf der Grundlage eines Selbstentladungsbetrages und einer Verbrauchskapazität gemäß Eigenschaften der Sekundärbatterie (2B, 3B).

8. Elektrische Vorrichtung nach Anspruch 3 oder 4, weiter mit:

   einem Mittel, das zu einer Zeit betätigt wird, die durch den Zeitgeber (4) spezifiziert ist, Betreiben des Messmittels (16, 17) und des Speichers (11, 12), Managen einer Restkapazität der Sekundärbatterie (2B, 3B) auf der Grundlage eines Selbstentladungsbetrages und einer Verbrauchskapazität gemäß den Eigenschaften der Sekundärbatterie (2B, 3B), und Verursachen, dass der Lader (8) die Sekundärbatterie (2B, 3B) lädt, wenn sie aufgeladen werden muss.

**Revendications**

1. Dispositif électrique (1) d'un véhicule électrique avec un minuteur (4), comprenant :

   une batterie secondaire rechargeable (2B, 3B) ;
   un moyen de mesure (16, 17) pour mesurer un état de ladite batterie secondaire (2B, 3B), et une mémoire (11, 12) pour stocker les informations mesurées de celle-ci et les informations relatives aux propriétés de ladite batterie secondaire (2B, 3B) ;
   une charge (10) d'un moteur électrique entraînée par une alimentation électrique fournie par ladite batterie secondaire (2B, 3B) ;
   un système de commande (6) pour commander l'entraînement de ladite charge (10) ;
   un minuteur (4) ayant une fonction de minuteur ;
   une unité d'affichage et d'utilisation (13) ayant une fonction de réglage de durée pour ledit minuteur (4) et une fonction d'affichage de la durée ;
   un système de gestion de batterie pour gérer ladite batterie secondaire (2B, 3B) sur la base des informations dudit moyen de mesure (16, 17) et/ou de ladite mémoire (11, 12) et des informations de durée dudit minuteur (4) ; et
   une interface (169) capable de connecter un chargeur (8) via un bus système (26) pour charger ladite batterie secondaire (2B, 3B) sur la base des informations dudit moyen de mesure (16, 17) et/ou de ladite mémoire (11, 12) et des informations de durée dudit minuteur (4).

2. Dispositif électrique selon la revendication 1, dans lequel
   ledit système de commande (6) a également une fonction de dit système de gestion de batterie pour gérer ladite batterie secondaire (2B, 3B) sur la base des informations dudit moyen de mesure (16, 17) et/ou de ladite mémoire (11, 12) et des informations de durée dudit minuteur (4).

3. Dispositif électrique (1) d'un véhicule électrique avec un minuteur (4), comprenant :

   une batterie secondaire rechargeable (2B, 3B) ;
   un moyen de mesure (16, 17) pour mesurer un état de ladite batterie secondaire (2B, 3B), et une mémoire (11, 12) pour stocker les informations mesurées de celle-ci et les informations relatives aux propriétés de ladite batterie secondaire (2B, 3B) ;
   une charge (10) d'un moteur électrique entraînée par une alimentation électrique fournie par ladite batterie secondaire (2B, 3B) ;
   un système de commande (6) pour commander l'entraînement de ladite charge (10) ;
   un minuteur (4) ayant une fonction de minuteur ;
   une unité d'affichage et d'utilisation (13) ayant une fonction de réglage de durée pour ledit minuteur (4) et une fonction d'affichage de la durée ;
   un chargeur (8) pour charger ladite batterie secondaire (2B, 3B) sur la base des informations dudit moyen de mesure (16, 17) et/ou de ladite mémoire (11, 12) et des informations de durée dudit minuteur (4) ; et
   une interface (169) pour connecter ledit chargeur (8) avec ledit moyen de mesure (16, 17) et/ou ladite mémoire (11, 12) et ledit minuteur (4) et ledit système de commande (6) via un bus système (26)

4. Dispositif électrique selon la revendication 3, dans lequel
   ledit système de commande (6) a également une fonction de système de gestion de batterie pour gérer ladite batterie secondaire (2B, 3B) sur la base des informations dudit moyen de mesure (16, 17) et/ou de ladite mémoire (11, 12) et des informations de durée dudit minuteur (4).

5. Dispositif électrique selon la revendication 1 ou 3, dans lequel

ladite batterie secondaire (2B, 3B), ledit moyen de mesure (16, 17) et ladite mémoire (11, 12) sont constitués de manière à être une unité de batterie intégrée (2, 3), et l'unité de batterie intégrée (2, 3) est montée sur un corps principal de dispositif électrique de façon à être attachable/détachable à celui-ci/de celui-ci.

6. Dispositif électrique selon la revendication 4 dans lequel
ladite unité d'affichage et d'utilisation (13) est dotée d'un moyen de spécification de temps pour spécifier un moment de fin de charge, et ledit chargeur (8) est doté d'un moyen de lancement de charge de sorte que la charge de ladite batterie secondaire (2B, 3B) est terminée à un moment spécifié par le moyen de spécification de temps.

7. Dispositif électrique selon la revendication 1 ou 3, comprenant en outre :

un moyen actionné à un moment spécifié par ledit minuteur (4), faisant fonctionner ledit moyen de mesure (16, 17) et ladite mémoire (11, 12), et gérant une capacité résiduelle de ladite batterie secondaire (2B, 3B) sur la base d'une quantité d'auto-décharge et d'une capacité de consommation selon les propriétés de ladite batterie secondaire (2B, 3B).

8. Dispositif électrique selon la revendication 3 ou 4, comprenant en outre :

un moyen actionné à un moment spécifié par ledit minuteur (4), faisant fonctionner ledit moyen de mesure (16, 17) et ladite mémoire (11, 12), gérant une capacité résiduelle de ladite batterie secondaire (2B, 3B) sur la base d'une quantité d'auto-décharge et d'une capacité de consommation selon les propriétés de ladite batterie secondaire (2B, 3B), et faisant en sorte que ledit chargeur (8) charge ladite batterie secondaire (2B, 3B) lorsqu'elle nécessite d'être chargée.

# F I G. 1

# F I G. 2

# F I G. 3

A1 — SET TIME SPECIFIED CHARGE

A2 — SPECIFY TIME SPECIFIED CHARGE MODE

A3 — SET CHARGE STARTING TIME

A4 — CALCULATE CHARGE COMPLETION TIME FROM REMAINING CAPACITY AND INDICATE TIME REQUIRED TO CHARGE/CHARGE COMPLETION TIME

A5 — SETTING FINISHED? N / Y

A6 — END

# F I G. 4

B1 — TIME SPECIFIED CHARGE

B2 — TIME SPECIFIED CHARGE? — N / Y

B3 — IS IT SPECIFIED TIME? — N / Y

B4 — START CHARGE

B5 — INDICATE TIME REQUIRED TO CHARGE/CHARGE COMPLETION TIME

B6 — CHARGE FINISHED? — N / Y

B7 — END

17

# F I G. 5

C1 — REFRESH TIME SPECIFIED CHARGE

C2 — TIME SPECIFIED CHARGE? — N / Y

C3 — IS IT SPECIFIED TIME? — N / Y

C4 — START REFRESH

C5 — INDICATE REFRESHING TIME + TIME REQUIRED TO CHARGE/REFRESH + CHARGE COMPLETION TIME

C6 — REFRESH FINISHED ? — N / Y

C7 — START CHARGE

C8 — INDICATE TIME REQUIRED TO CHARGE/CHARGE COMPLETION TIME

C9 — CHARGE FINISHED? — N / Y

C10 — END

# F I G. 6

D1 — ( SET CHARGE COMPLETION TIME SPECIFIED CHARGE )

D2 | SPECIFY CHARGE COMPLETION TIME SPECIFIED CHARGE MODE |

D3 | SET CHARGE COMPLETION TIME |

D4 | OBTAIN CHARGING TIME FROM PRESENT TIME AND COMPLETION TIME, AND INDICATE REMAINING CAPACITY VALUE AT COMPLETION TIME BASED ON REMAINING CAPACITY |

D5 — N ◇ SETTING FINISHED? ◇ Y

D6 — ( END )

19

# F I G. 7

E1 CHARGE COMPLETION TIME SPECIFIED CHARGE

E2 START CHARGE

E3 INDICATE REMAINING TIME OF CHARGE AND/OR REMAINING CAPACITY

E4 CHARGE FINISHED? N Y

E5 IS IT SPECIFIED TIME? N Y

E6 END

20

# F I G. 8

F1 CORRECT REMAINING CAPACITY

F2 IS IT SPECIFIED TIME? — N

Y

F3 BRING CONTROLLER AND RELATED PARTS INTO OPERATING STATE BY WU SIGNAL

F4 OBTAIN INFORMATION CORRESPONDING TO BATTERY PROPERTY SUCH AS TEMPERATURE

F5 CALCULATE CORRECTION AMOUNT FROM ELAPSED TIME FROM PREVIOUS TIME AND OBTAINED INFORMATION AND CORRECT REMAINING CAPACITY

F6 SET DEVICE AT POWER-SAVING STATE

F7 END

# F I G. 9

```
G1        ( CORRECT REMAINING
            CAPACITY )
                  │
                  ▼
G2            ┌─────────────┐      N
          <   IS IT          >─────┐
              SPECIFIED TIME?      │
            └─────────────┘        │
                  │ Y              │
                  ▼                │
G3   ┌────────────────────────────┐
     │ BRING CONTROLLER AND RELATED│
     │ PARTS INTO OPERATING STATE BY│
     │ WU SIGNAL                   │
     └────────────────────────────┘
                  │
                  ▼
G4   ┌────────────────────────────┐
     │ OBTAIN INFORMATION          │
     │ CORRESPONDING TO BATTERY    │
     │ PROPERTY SUCH AS TEMPERATURE │
     └────────────────────────────┘
                  │
                  ▼
G5   ┌──────────────────────────────┐
     │ CALCULATE CORRECTION CAPACITY │
     │ FROM ELAPSED TIME FROM PREVIOUS│
     │ TIME AND OBTAINED INFORMATION AND│
     │ CORRECT REMAINING CAPACITY    │
     └──────────────────────────────┘
                  │
                  ▼
G6            ┌─────────┐      N
          <    CHARGE?    >──────┐
            └─────────┘          │
                  │ Y            │
                  ▼              │
G7   ┌────────────────────────┐  │
     ‖      CHARGE ACTION      ‖  │
     └────────────────────────┘  │
                  │◄─────────────┘
                  ▼
G8   ┌────────────────────────┐
     │ SET DEVICE AT POWER-SAVING STATE │
     └────────────────────────┘
                  │
                  ▼
G9        (         END         )
```